(19) Europäisches Patentamt
European Patent Office
Office européen des brevets

(11) Publication number: **0 007 976**
**A1**

(12) # EUROPEAN PATENT APPLICATION

(21) Application number: **79101528.2**

(51) Int. Cl.³: **G 03 C 1/72**, G 03 F 7/10

(22) Date of filing: **21.05.79**

(30) Priority: **22.05.78 US 907874**

(43) Date of publication of application: **20.02.80**
**Bulletin 80/4**

(84) Designated Contracting States: **BE CH DE FR GB IT NL SE**

(71) Applicant: **Western Electric Company, Incorporated, 222 Broadway, New York N.Y. 10038 (US)**

(72) Inventor: **Bowden, Murrae John Stanley, 42 Overhill Road, Summit, New Jersey 07901 (US)**
Inventor: **Stillwagon, Larry Edward, 73 Beechwood Road, Summit, New Jersey 07901 (US)**
Inventor: **Thompson, Larry Flack, 712 Long Hill Road, Gillette, New Jersey 07933 (US)**

(74) Representative: **Blumbach, Paul-Günter, Dipl.-Ing. et al, Blumbach.Weser.Bergen.Kramer Zwirner.Brehm Patentanwälte Radeckestrasse 43, D-8000 München 60 (DE)**

(54) **Lithographic resist and device processing utilizing same.**

(57) Copolymers of poly-alpha substituted acrylonitrile, e.g., methylacrylonitrile, manifest film forming properties, adhesion to usual substrates, sensitivity to actinic radiation, resolution, contrast, and other properties of significance for fine line lithographic use. Contemplated use includes fabrication of masks for manufacture of large scale integrated circuits. Stability to attack by ions and reactive chemicals, as well as thermal stability, are sufficient to permit use in direct processing of such circuits. Integrity of pattern features may be further assured by post-development treatment. Heating results in rearrangement to render the patterned resist more stable under a variety dry processing conditions.

**EP 0 007 976 A1**

BLUMBACH · WESER · BERGEN · KRAMER
ZWIRNER · BREHM

PATENTANWÄLTE IN MÜNCHEN UND WIESBADEN

Patentconsult Radeckestraße 43 8000 München 60 Telefon (089) 883603/883604 Telex 05-212313 Telegramme Patentconsult
Patentconsult Sonnenberger Straße 43 6200 Wiesbaden Telefon (06121) 562943/561998 Telex 04-186237 Telegramme Patentconsult

Western Electric Company, Incorporated BOWDEN 6-1-18
New York, N. Y. 10038 USA

# LITHOGRAPHIC RESIST AND DEVICE PROCESSING UTILIZING SAME

## Background of the Invention

### A. Technical Field

Small circuits or circuit elements of feature size of the order of a few micrometers or smaller generally undergo one or more lithographic delineation steps in fabrication. One such category of circuits often fabricated in and on epitaxial silicon is known as large scale integration (LSI). Prevalent manufacture is based on sets of discrete masks patterned by means of ultraviolet light, electron beam or other actinic radiation. An alternative approach, known as "direct processing", is based on primary pattern delineation in masking layers affixed directly to the device or circuit during manufacture.

All such processes involve primary or secondary pattern delineation to eventually permit plating, etching or other modification of underlying active material exclusively in bared regions of apertured masking layers.

### B. History

Historically, printed circuits and then integrated circuits were patterned by draftsmen. A sophisticated product based on the primary design eventually evolved. This product, a "mask" containing many precisely placed identical patterns, was produced by photographically reducing, stepping and repeating the

design. Patterns so produced in radiation sensitive "resist" layers were often replicated in underlying metal to result in "hard" masks. Manufacture of typical silicon integrated circuits (SIC) may involve use of a set of ten or more such masks, members of which are necessarily precisely delineated and positioned so as to permit registration.

As the trend toward miniaturization continued; as device density increased; as minimum feature size decreased to micrometer dimensions, alternative approaches to primary pattern delineation were adopted. A procedure now gaining impetus involves delineation on a 1:1 scale by means of a programmed electron beam. Regardless of how such masks are produced, masters or copies are used in the replication of patterns in resist layers formed as adherent coatings on the circuit material being processed. In SIC's, such a resist layer is formed in each lithographic step of the processing sequence. Replicated relief patterns serve to mask the circuit material during procedures such as etching, plating, ion implantation, and the like.

At this time, long wavelength ultraviolet (near u.v.) is the prevalent actinic radiation used for replicating patterns. In recognition of the fact that significant further miniaturization may be impeded by diffraction, by standing waves, and even by wavelength dimensions, some considerable effort is being expended on resists and procedures which depend upon other forms of radiation--e.g., short wavelength ultraviolet (far u.v.), X-ray, as well as accelerated charged particles--notably electrons.

There is a consensus of opinion that mask technology will, itself, eventually become a limitation on device miniaturization. Use of maskless technologies, which may be forestalled to some extent by use of shorter wavelength replication actinic radiation, is generally expected to become significant for design rules in the micrometer or submicrometer range. Progression from large

scale integration (LSI), to the next level of integration--sometimes called very large scale integration (VLSI)--is expected to mark a transition to "direct processing."

Direct processing contemplates primary pattern delineation in a resist layer on the circuit material, itself. So, rather than delineate a pattern in a resist layer to produce a discrete mask, the pattern is delineated directly in a resist layer on the device being fabricated. Demands placed on resist material are sometimes implicit--appropriate adherence, stability, sensitivity to desired radiation, resolution, contrast, etc. All such requirements become more stringent for increasing miniaturization. So, for example, adherence must be more nearly perfect, defect count must be reduced, etc. Other requirements now imposed on the direct processing resist are transferred from those originally demanded of the replicating resist. In addition to the enumerated and other lithographic requirements, direct processing resists and fabrication procedures designed to accommodate them must be such as to result in minimal deterioration of patterns during a wide variety of processing steps. Particularly harsh are the "dry" processing steps considered preferable to "wet" processing for very fine scale. Dry processing--e.g., plasma etching, sputter etching, ion milling, reactive ion etching--may have a pronounced deteriorative effect on patterned resist materials.

Polymethyl methacrylate (PMMA) is a still popular electron beam resist. While generally considered of insufficient sensitivity to satisfy commercial throughput requirements, PMMA is otherwise a near-perfect positive resist for use in discrete masks (positive characteristics are due to selective removal of irradiated portions by increased solubility caused by reduction in molecular weight).

The generally acknowledged suitabilty of PMMA as a positive acting electron beam resist has prompted study directed toward increasing sensitivity.

In one study, MMA was copolymerized with acrylonitrile (ACN). See 35 (2) Organic Coatings and Plastics Chemistry Preprints, 258 (1975). While reported sensitivity was significantly increased for such a copolymer containing 7 mole percent ACN, attempts to reproduce the work resulted in an electron sensitivity of only 6 x $10^{-5}$ coulombs/$cm^2$--a value considered undesirably low. Use of increased ACN content in the copolymer only resulted in decreasing sensitivity. 37 (2) "Coatings and Plastics Preprints" 38 (1977) contains a preprint of a talk presented August 29, 1977. The talk was concerned with work by the present inventors. In this work PMMA was copolymerized with alpha-methyl acrylonitrile (MACN). In these studies it was found that MACN showed some improvement over ACN as a comonomer with MMA. It was reported that lithographic sensitivity relative to MMA was increased, peaking within the weight percent MACN range of 10 to 20 percent. It was found that sensitivity for the copolymer was reduced with increasing MACN to result in decreased sensitivity relative to PMMA for MACN content at or above 45 percent.

For direct processing, PMMA is of only restricted utility, since it rapidly degrades by depolymerization during many forms of dry processing. Dry processing stability may be improved by chemical crosslinking subsequent to pattern delineation; see Third International Conference Electron, Ion Beam Sci. Technol, by E. D. Roberts, ed, R. Bakish, page 104. Such treatment has no effect on lithographic sensitivity.

## C. Summary of the Invention

### 1. Problem

Fabrication of fine detail (micrometers or less) devices or circuits by procedures involving lithography results in imposition of a number of requirements. Regardless of fabrication technique; regardless of the type of actinic radiation utilized, requirements imposed on resist materials include sufficient resolution, contrast, shelf life, etc. Since brightness available from radiation

sources is finite, sensitivity of the radiation sensitive material (the resist) may be significant. This is important in fine feature primary pattern delineation, where small beam diameter inherently increases writing time for given brightness.

Where the resist is used as a replication resist on the device material, or where the device material is processed directly by a maskless technique, the requirement of compatibility of resists and processes may be limiting. For small feature size, "dry processing"--processing involving use of ion beams, plasmas and the like--translates into extremely demanding requirements for radiation stability of the patterned resist.

Positive resists--material in which patterns result from removal of irradiated material--may be inherently unstable to device processing conditions (delineation generally involves some depolymerization by irradiation so as to increase solubility). It has been recognized that such materials are likely to depolymerize during dry processing. In addition, use of thermoplastic resists may result in loss of image integrity due to flow at elevated temperatures encountered during processing.

Polymethyl methacrylate (PMMA) is a positive resist which has found use in electron beam lithography. While there is much to recommend it, it is significantly lacking in lithographic sensitivity, resulting in low throughput. This characteristic has prevented its general adaptation to commercial processing. In addition, stability of PMMA to many wet and dry agents used in device processing is inadequate.

2. <u>Solution</u>

A family of positive resists and compatible processes are described. Actinic radiation sensitivity, as well as image stability, of included materials are sufficient to permit designation of resist-processing couples displaying both adequate lithographic sensitivity and sufficient processing stability for many contemplated fabrication approaches.

Resist materials of the invention are based upon substituted or unsubstituted methacrylonitrile (conveniently designated MACN). MACN may be homopolymerized to result in a resist of sensitivity comparable to that of PMMA while of a stability easily sufficient for the most demanding device fabrication. Copolymerization with any of a family of comonomers increases sensitivity significantly--factors of 5 to 10 are attainable. While copolymerization with such monomers tends to decrease processing stability, preferred monomer ratios yield copolymers still of sufficient stability for most purposes.

Optimization of results is dependent upon careful selection of developers. In fact in certain embodiments choice of such developers represents a significant advance in itself. Appropriate choice may be responsible in large part for effectively high lithographic sensitivity.

An advantage of resists in accordance with the invention is the possibility of post-development treatment to result in still further improved stabilization. This effect is attributable to the nature of the MACN itself. In certain embodiments where MACN content is small, use may be made of minor amounts of an additional comonomer which may itself be crosslinked to improved stabilization.

Resists and processes are suitable for e-beam pattern delineation. Primary and secondary patterning suitably employ a variety of delineation sources.

## Detailed Description

### I. Introduction

The invention is concerned with compatible processes and resists for lithographic pattern delineation. A preferred embodiment is concerned with "dry processing"--e.g., processing in which resist patterns serve to shield underlying, adherent surface regions during processing involving charged particles, such as, ions, ion radicals or electrons, or other reactive vapor species, such as free radicals. This is defined as a preferred embodiment for the reason that advantage is taken of two useful

characteristics: (1) substantial throughput due to an expedient level of radiation sensitivity compatible with other resist characteristics and (2) resist stability to dry processing environments. While the invention is most meaningfully defined in terms of the resist composition-process pair, it is convenient to discuss it in terms of the two separately.

## II. Composition

### A. General

Resist compositions are dependent upon polymerized products of a class of monomers designated MACN. This designation is intended to represent the entire class of alkyl or aryl substituted α-halo, α-methyl or α-cyano acrylates. Homopolymers are the most stable of the inventive resists under many conditions. A preferred class from the standpoint of improved lithographic sensitivity is dependent upon copolymerization with a "diluent". Such diluent, likely a comonomer included in amounts of as little as 5 weight percent based on MACN-diluent, results in an effective increase in sensitivity of two-fold or better under many conditions.

Stability of patterned resist may often be improved by post-development treatment, and such is discussed in certain embodiments. Generally, heating results in rearrangement probably enhancing the mechanism inherently responsible for the intrinsic stability of MACN itself. Where further stabilization is desired--likely of concern in generally nonpreferred embodiments containing relatively small amounts of MACN, an additional comonomer may be included. This comonomer, tetrahydrofurfuryl methacrylate (THFM) typically added in small amounts--below 5 weight percent based on MACN-diluent-THFM, may be thermally crosslinked in the presence of oxygen.

Other compositional variations are concerned with additives for a variety of known purposes. So, for example, whereas cross-section for a specific X-ray wavelength may be increased by permitted selection of halogen substituent in MACN as provided below, such

halogen-containing materials, or, in fact, other appropriate materials may be admixed physically or even copolymerized. Antioxidants, antiozonants and adhesion-promoting additives are among those contemplated.

B. Monomers

(1) MACN: This monomer class is structurally depicted as:

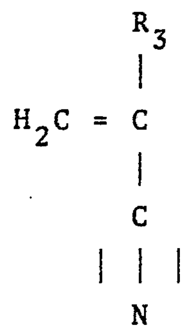

in which: $R_3 = CH_3$, Cl or Br

While it is necessary that there be a non-hydrogen substituent at the $R_3$ position, there is little preference for any of the permitted named substituents. For most purposes, this monomer takes the familiar form of methacrylonitrile with replacement of the methyl grouping being made largely for the purpose of tailoring cross-section to the desired actinic radiation. While a significant purpose dictating use of this monomer concerns improved stability during dry processing, it is also significant that the $R_3$ substituent results in a quaternary carbon which is, itself, radiation sensitive.

(2) Diluent: This optional ingredient, included as a comonomer, is generally so designated since for most purposes resulting changes in resist characteristics are ascribed simply to alteration in MACN behavior. MACN stability is ascribed to intramolecular rearrangement necessarily induced during irradiation. This rearrangement, so valuable for many purposes, competes with radiation-induced chain scission to result in reduced effective sensitivity. The major effect of diluent is to lessen competing mechanism and thereby result in

effectively increased lithographic sensitivity.

Diluents are characterized by relatively low probability of radiation-induced polymerization or crosslinking. This property is conveniently expressed as a requirement of a value for G(x) of less than about 2. G(x) is defined in Atomic Radiation and Polymers, A. Charlesby, Perganon Oxford Press, (1960). Exemplary materials include alpha-substituted acrylates (this class designated MMA) as well as other low G(x) monomers, e.g., isobutylene, vinylacetic acid. A category of MMA monomers is depicted:

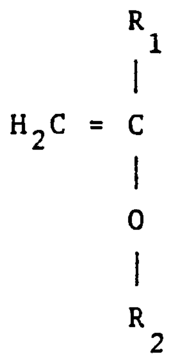

in which: $R_1$ = $CH_3$, Cl, Br, or CN

$R_2$ = 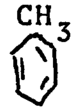 or alkyl group (aliphatic or cyclic) containing from 1 to 6 carbon atoms

(3) THFM: Most resist properties discussed depend largely upon the two already defined monomers: MACN and diluent. An embodiment makes use of yet another comonomer (THFM) structurally depicted as:

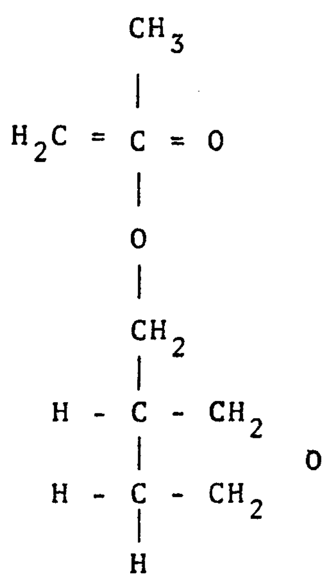

THFM may be cross-linked at elevated temperature in the presence of oxygen to reduce flow and assure pattern integrity as discussed.

C. The Polymer

(1) Composition

Most significant resist properties are determined by relative amounts of MACN and diluent. For most purposes properties to be considered in specification of the MACN/diluent ratio are lithographic sensitivity and stability. Where the latter property is of primary concern preference for high ratio exists. The most stable composition under many processing conditions is in fact the homopolymer of MACN. Lithographic sensitivity is increased within increasing diluent content--for many forms of radiation a factor of 2 is realized for as little as 5 weight percent diluent (always expressed in terms of MACN+diluent). Diluent content of 10 percent or more on the same basis may result in five-fold sensitivity improvement or greater.

In most forms of lithographic processing a preference exists for a maximum diluent inclusion - no more than 50 weight percent. Under most circumstances further inclusion does not result in further increase in sensitivity but results only in further stability impairment. Nevertheless on the basis that use of as much as 70 weight percent diluent still results in a resist of sufficient stability for many purposes, a broad range is so defined.

The polymer on which the resist characteristic is based has been defined first in terms of the generic two-member material and then in terms of the three-membered embodiment. In either event, the polymer constituents so defined constitute a minimum of eighty weight percent of the final polymer. It is generally not contemplated that other comonomers will result in substantial improvement either in sensitivity or in radiation stability. Additions are likely for other purposes, such as, improved adhesion

or increased absorption cross-section for particular actinic radiation. From a general standpoint, however, appropriate resist material is properly defined as being of such composition that lithographic sensitivity and dry processing chemical stability parameters are determined primarily by the named constituents.

(2) Molecular Weight

It is well known that both molecular weight and molecular weight distribution are significant design parameters for resist material. The first is relevant to such considerations as ease of application, sensitivity and dissolution. Since spread in molecular weight results in a spread in such parameters, best resolution is attained for narrow molecular weight distribution. A range of weight average molecular weight appropriate for resists of the invention is from 500,000 to 5,000,000. Lower molecular weights adversely affect sensitivity; greater weights cause difficulty in application. Distribution in terms of the fraction $\frac{M_w}{M_n}$ (where $M_w$ is weight average molecular weight and $M_n$ is number average molecular weight) of up to about three is generally attainable and considered acceptable for all but the most demanding processing.

III. Processing

This section is set forth in general terms with ranges indicated where suitable. Best modes contemplated are set forth in specific terms under Examples.

A. Patterning

Contemplated processes include primary pattern delineation, whether in a mask or a maskless process, as well as pattern replication (secondary pattern delineation). This section outlines procedures which may be followed in delineation including: (1) application and other initial preparation; (2) exposure; (3) development; (4) subsequent resist processing.

(1) Application and Other Initial Preparation

The resist solution is prepared by dissolving the polymeric material in a suitable solvent. The solution is then coated on a substrate using, for example, conventional

spin coating techniques. Exemplary solvents are chlorobenzene and methoxyethylacetate. Factors dictating their choice include boiling point (90-150 degrees C): lower boiling point increases the need for precautions to avoid loss during deposition; higher boiling point results in inconvenient evaporation rates during coating). Concentration, again, is determined by usual considerations, such as desired film thickness and viscosity requirements for contemplated coating conditions. In general a solute concentration of from 3 to 12 weight percent solute is useful for flood-spin coating.

While application may take many forms, the examples make use of conventional coating by flooding and subsequently spinning. (Choice within the range of from 1,000 - 10,000 rpm results in an adequate thickness range for the indicated solute-solvent concentration range.)

Following spinning, the air dried film is prebaked to remove residual solvent. Typically, temperatures of about 150 degrees C for a period of a few hours is suitable. If THFM is present, it is desirable to exclude oxygen or other oxidizing ingredients from the atmosphere during prebaking to avoid cross-linking. Prebaking in vacuum avoids cross-linking. Prebaking in vacuum may also minimize likelihood of cyclization of MACN.

(2) Exposure

Generally contemplated film thicknesses require a total absorbed dose of the order of 1-3 microcoulombs/cm$^2$. In electron beam lithography, this is equivalent to an incident dose of approximately twice for an accelerating voltage of 10 kilovolts--i.e., of from 2-6 microcoulombs/cm$^2$. Accelerating voltage over the range of from 5-20 kilovolts results in compensating increasing electron density and decreasing absorption cross-section for usual electron sources so that throughput is not significantly affected.

Required absorbed dosage is independent of the form of actinic radiation used. Absorption cross-section, however, varies appreciably. For example, even with large

halogen concentration usual extinction ratios may result in only 10 percent absorption for x-ray exposure.

Dosage indicated is in terms of removal of irradiated material without any thinning of unirradiated material. Data in the literature is sometimes based on forced development in which unirradiated material is thinned during development. On this basis, dosage may be reduced from the indicated values.

(3) Development

Choice of developer is critical. It takes into account the fact that irradiated resist within the inventive compositions does not result solely in simple chain scission. It is very important to take account of the fact that some rearrangement is attendent upon scission. Developer is chosen not for its dissolution effect on the unirradiated resist, but for its dissolution effect on the irradiated resist. Failure to take this into account may serve to explain seemingly inconsistent results reported in the literature.

Literature reported results often rely on a solvent/nonsolvent pair for the unirradiated positive resist. For PMMA a literature-reported pair is ethyl acetate/amyl acetate. Relative amounts are commonly chosen by increasing the amount of nonsolvent until the unirradiated resist is largely unaffected. Use of such a solvent/nonsolvent pair for MMA copolymer resist may be improper. For example, where copolymerization is with MACN the underlying assumption that irradiated and unirradiated resist are chemically identical becomes incorrect so that the developer is improper. Developer must be chosen with respect to dissolution properties of material to be dissolved, i.e., the irradiated material which in the instance of an MACN-containing polymer is changed substantially.

Developer is properly designed by choosing a solvent-containing solution with respect to irradiated material of the invention.

(4) Subsequent Resist Processing

Post-baking is generally desirable to free the now developed resist of developing solvent. Under certain circumstances, as in plasma etching, where some heating implicitly results, a separate post-baking step may not be necessary. For resist layer thicknesses of up to about one micron solvent is substantially removed by baking for a period of up to about thirty minutes at temperatures of up to about 120 degrees C. Atmosphere is not generally critical except where THFM is present and cross-linking is desired.

Where THFM is present, and it is desired to minimize flow, post-baking is carried out in the presence of oxygen (e.g., air or $O_2$) to bring about cross-linking. Heating for the equivalent of one hour at a temperature of 150 degrees C is sufficient for a high degree of cross-linking as well as solvent removal. A significant change in flow properties results from air heating for 15 minutes at a temperature of 150 degrees C or equivalent and this may suffice depending on feature size and expected processing temperatures.

B. Mask Making

It is contemplated that material/process pairs of the invention may be valuably incorporated in the fabrication of masks. Use of the invention is particularly appropriate for extremely fine feature masks where dry processing such as plasma etching is contemplated for the now underlying supported layer in which the pattern is to be replicated. For many purposes, typical structures at this stage in processing consist of a highly polished glass substrate supporting a thin layer of chromium or chromium oxide which, in turn, supports the now delineated resist pattern. In such procedures, need for heat extraction may be avoided or lessened by THFM inclusion and post-delineation curing as in direct processing. A chromium or chromium oxide layer of a thickness of 0.5 micrometers or

less may be pattern delineated by exposure to a conventional plasma environment, e.g., a gaseous mixture of chlorine and oxygen with a chlorine content of between 30 and a 70 volume percent, a pressure of 0.1 - 0.4 Torr, and a power input of 100 - 500 watts using a conventional tubular plasma reactor (13.5 megaHertz). These plasma conditions result in an etch rate of chromium or chromium oxide of between 10 and 40 nanometers/minute. Following replication, the resist pattern is usually stripped, for example, by sulfuric acid-potassium dichromate stripping solutions or oxygen plasma treatment.

Resist compositions of the invention may be used to mask underlying surfaces during conventional wet chemical etching. For example, the glass supported metal or metal oxide layer, in turn, supporting the delineated resist is dipped in or sprayed with -- e.g., ceric ammonium nitrate/acid etching solution. Room temperature treatment for one minute is generally sufficient--in usual practice, etching is continued for thirty seconds beyond clearing.

As elsewhere in this description, conventional practice is largely in terms of exemplary procedures. As in other sections, alternatives are appropriate--e.g., potassium permanganate-based wet etches, as well as reactive ion etching or sputter etching may be utilized in "hard" mask fabrication.

C. Device Fabrication

This section is largely in terms of fabrication of large scale integrated circuits, LSIs. At this time most significant contemplated use concerns fabrication in/on epitaxial silicon layers supported by silicon substrates. There is also interest in other semiconductors as well as in magnetic devices such as bubble devices. Fabrication of typical bubble devices involves patterning of magnetic garnet epitaxial layers and permalloy. Integrated optic circuits represent and her example of fine line devices which may be fabricated by use of the invention. Materials to be patterned may include $SiO_2$, $LiNbO_3$, $LiT_2O_3$, etc.

The inventive teaching is of particular significance in the fabrication of fine features by dry processing. However, commercial practice which favors minimum inventory and efficient use of apparatus may result in use in less demanding processing steps as well.

A brief fabrication outline of a silicon integrated circuit is set forth for illustrative purposes. The procedure contemplates use of a silicon wafer bearing an epitaxial layer of device grade silicon of appropriate conductivity type, resistivity, thickness, etc. The listing is generally in a form appropriate for MOS fabrication. A variety of alternatives which may concern bipolar, as well as MOS devices, are contemplated. Each of the enumerated steps assumes prior deposition, delineation, and processing to result in a completed resist pattern. The outline is in tabular form with each step where suitable in terms of two alternative entries--the first directed to wet processing and the second to dry. Also unstated, but common to each level with the possible exception of the terminal step, (unless otherwise noted) is stripping of the resist pattern after processing.

Dry processing contemplates modification of bared regions of substrate by a vapor agent. For these purposes, dry processing contemplates all nonliquid/nonsolid media whether uncharged or charged; whether of balanced or unbalanced charge. The term "plasma" is used without regard to special meanings sometimes assigned by specialists in different disciplines--e.g., it does not necessarily connote a medium within a volume in which charges are balanced on a macroscale. At this time, a variety of dry processing steps are in use. Descriptive terms sometimes overlapping but all contemplated where the term dry processing is used include: ion etching, ion beam milling, reactive ion etching, plasma etching, reactive sputter etching, sputter etching, and gas phase chemical etching.

Dry processes may also be designed to modify underlying substrates through material introduction or

other mechanism, as well as removal. Such dry processing may involve true material addition as an implantation, vacuum deposition, sputter deposition, as well as deposition through reduction or oxidation reactions; or other change, such as, local strain enhancement, e.g., as resulting from lattice distortion due to high energy bombardment. The enumeration is not intended to be exhaustive.

Inverse masking (lift-off) is conventionally used for delineating final metallization levels, e.g., on semiconductor devices, as well as photomask patterns. The process entails pattern delineation of the resist followed by flood deposition (overall deposition covering both masked and unmasked regions) of the desired film and subsequent stripping of the resist-film in a suitable solvent. To the skilled artisan, it is meaningful to consider such a combined process as "dry processing" for the reason that flood deposition--ordinarily by use of a vapor species--is resolution controlling.

All such designated species, as well as others that may evolve, are desirably incorporated in circuit fabrication, generally, to more easily realize fine resolution and line width control.

While an advantage of the inventive resists is their comparative stability to dry processing media, they have been found suitable for wet processing procedures, as well. It is not generally alleged that these resists are necessarily superior to known resists in use at this time. It is possible that their use in wet processing may be a matter of convenience. In general, in commercial processing economy in use of apparatus as well as in inventory control is realized by minimizing the number of agents used. Wet etching contemplated, therefore, includes the whole spectrum of procedures in use or to be used. A listing of contemplated wet processes includes: liquid etching, electrode, electroless, or displacement plating.

Silicon LSI Fabrication Procedures

(1) Etching of CVD Silicon Nitride

DRY:

Reactor: Parallel plate (Conditions noted are for a 15" (381 mm.) diameter reactor)

Gas mixture: 80-75 vol. % tetrafluoromethane (TFM)-remainder oxygen

Power: 75-450 watts

Pressure: 0.1-0.5 Torr

Flow Rate: 60-250 cubic centimeters/minute

Etch Rate: 100-300 nanometers/minute

(2) Etching of Pyrolytic Silicon Nitride

DRY:

Reactor: Parallel plate (conditions noted are for a 15" (381 mm.) diameter reactor)

Gas Mixture: 40-65 vol. % perfluoroethane remainder trifluoromethane

Power: 750-1250 watts

Pressure: 0.5-0.9 Torr

Flow rate: 60-120 cu. cm/min.

Etch rate: 15-35 nanometers/min.

(3) Etching of Phosphorous Doped Glass

WET:

The liquid etch is a solution of 15 parts by volume hydrofluoric acid; 10 parts by volume nitric acid; and 300 parts by volume water. The etch rate from this mixture is approximately 12-15 micrometers/min.

DRY:

Dry etching conditions are identical to that of pyrolytic silicon nitride with a resulting etch rate of 100-200 micrometers/min.

(4) Etching of Polysilicon

WET:

The liquid etchant is a mixture of 3 parts by volume hydrofluoric acid and 5 parts by volume nitric acid. The etch rate, typically 20 nanometers/min., is dependent on the type of amorphous silicon being etched.

DRY: Isotropic Dry Etching

| | |
|---|---|
| Reactor: | 15" (381 mm.) diameter parallel plate |
| Gas Mixture: | 85-95 vol.% carbon tetrafluoride, remainder oxygen |
| Power: | 100-300 watts |
| Pressure: | 0.2-0.4 Torr |
| Flow rate: | 90-160 cu. cm/min. |
| Etch rate: | 100-200 nanometers/min. |

DRY: Anisotropic Dry Etching

| | |
|---|---|
| Reactor: | 15" (381 mm.) diameter parallel plate |
| Gas Mixture: | 70-90 vol. % perfluoroethane remainder trifluorocholomethane |
| Power: | 300-800 watts |
| Pressure: | 0.2-0.5 cu. cm/min. |
| Flow rate: | 60-150 cu. cm/min. |
| Etch rate: | 80-130 nanometers/min. |

(5) Etching of Aluminum and Aluminum Alloys

WET:

The wet etchant is a mixture of 85 parts by volume phosphoric acid; 5 parts acetic acid; 5 parts nitric acid; and 5 parts water. The etch rate is approximately 1 micrometer/min.

DRY:

| | |
|---|---|
| Reactor: | 15" (381 mm.) diameter parallel plate |
| Gas Mixture: | 75-95 Vol. % carbon tetrachloride, remainder helium. |
| Power: | 1,000-2,000 watts |
| Pressure: | 0.2-0.5 Torr |
| Flow rate: | 900-1500 $cm^3$/min for $CCl_4$ with He flow rate is adjusted to |

| | |
|---|---|
| | result in the desired total pressure |
| Etch rate: | 800-1500 nanometers/min. Currently this is the most rigorous of all plasma etching conditions with the resist frequently being subjected to temperatures in excess of 250 degrees C. |

(6) Etching of Silicon Dioxide (thermal & CVD)

WET:

The liquid etchant is a standard buffered acqueous solution containing 34.6 weight percent ammonium fluoride and 6.8 weight percent hydrofluoric acid. The etch rate of this mixture is 100 nanometers/minute.

DRY:

Dry etching is done using the same conditions as phosphorous doped glass resulting in an etch rate of 60-100 nanometers/min.

III. Examples

Example 1: A 2,000 milliliter resin reaction vessel equipped with a variable speed stirrer, reflux condenser, thermometer, and sample withdrawing tube is charged with the following ingredients: 250 milliliters MMA; 250 milliliters MACN; 500 milliliters benzene. This mixture is heated to reflux, and after 30 minutes of refluxing, 0.4 milligrams of benzoyl peroxide is added. The reaction is allowed to continue for 8 hours with the resulting yield of 14 grams of copolymer. The reaction mixture is diluted with 500 milliliters of acetone and precipitated dropwise into 50 liters of methanol. The

precipitated copolymer is dissolved in one liter acetone and, again, precipitated in 12 liters of methanol. The precipitated copolymer is dried under vacuum for 48 hours. Analysis of the polymer indicates the copolymer composition contains 50 percent MACN with the remainder MMA. The molecular weight as determined by gel permeation chromotography is $M_w = 8 \times 10^5$, $M_n = 3.2 \times 10^5$ with a distribution of ~2.5. Six grams of this polymer is dissolved in 100 milliliters of chlorobenzene and filtered. A silicon wafer with 0.5 micrometers of aluminum film is spin-coated at 2,000 rpm with a resist solution. The resulting resist thickness is 1.0 micrometers. The resist-coated substrate is prebaked at 150 degrees C for one hour and exposed with a scanning electron beam to a dose of 8 microcoulombs/$cm^2$ at 20 kV. Development of the exposed film is effected by dipping into a solution of methyl isobutyl ketone, for seven minutes. The patterned resist-substrate is baked at 150 degrees C for one hour. The bared aluminum is etched in a plasma assisted dry etching procedure as previously described under (5) Etching of Aluminum and Aluminum Alloys (DRY). The plasma assisted etching results in some polymer flow and in removal of approximately 5,000 Angstroms of resist. The resulting resolution is better than 1 micrometer.

Example 2: The procedure of Example 1 is repeated with the exception that an oxidized silicon substrate with a thickness of 0.5 micrometers is used. Etching of the silicon dioxide is effected with a plasma assisted etching technique as described in (6) Etching of Silicon Dioxide (DRY). The resolution in this system is found to be at least 0.500 micrometers.

Example 3: The procedure of Example 2 is repeated with the exception that a liquid etching technique described in (6) Etching of Silicon Dioxide (WET).

Example 4: The procedure of Example 1 is repeated with the exception that a 1.0 micrometer

polysilicon film is deposited on the silicon wafer prior to resist application. Etching of the polysilicon film is effected with a plasma assisted etching technique as described in (4) Etching of Polysilicon (DRY).

Example 5: The procedure of Example 1 is repeated except that 150 milliliters of MACN is used in the polymer preparation. The resulting copolymer contains 47 percent MACN and has a molecular weight ($M_w$ = 7 x $10^5$) with a distribution of 2.5. The resist is processed in a manner identical to Example 1. The plasma assisted etching resistance of the polymer is improved over that of Example 1 (less polymer flow and lower polymer film removal rate). The resolution of the resulting etched aluminum pattern is again better than 1.0 micrometers.

Example 6: A 1,000 milliliter resin reaction vessel equipped as in Example 1 is charged with 250 milliliters of MACN; and 250 milliliters of benzene. The mixture is heated to reflux and after fifteen minutes of refluxing, 0.4 milligrams of benzoyl peroxide is added. The reaction is continued for two hours. The resulting polymer solution is precipitated into 6 liters of methanol and the polymer is collected. The polymer is dissolved in 500 milliliters of acetone and, again, precipitated into 6 liters of methanol. The resulting purified copolymer is dried over vacuum at room temperature for 48 hours. Polymer composition as determined from elemental analysis is found to be 100 percent MACN. The molecular weight, as determined by gel permeation chromotography, is found to be $M_w$ = 2.0 x $10^5$ with a distribution of ~2.5. Six grams of polymer are dissolved in 100 milliliters of methoxyethyl acetate. The resist is spin coated on a substrate of a 0.5 micrometer aluminum layer on silicon at 2,000 rpm resulting in a resist thickness of ~1.0 micrometer. The film is prebaked at 150 degrees C in air for one hour. The cross-linked film is then exposed with a programmed electron beam with a dose of ~30 microcoulombs/$cm^2$ at

an accelerating voltage of 20 kilovolts. Development of the exposed film is effected by dipping into 90:10 methylethyl ketone/isopropyl alcohol (MEK/IPA) mixtures for four minutes. The sample is subjected to a plasma assisted etching for aluminum and aluminum alloys as described in (5) Etching of Aluminum and Aluminum Alloys (DRY).

Example 7: A 250 milliliter resin reaction vessel equipped with a variable speed stirrer, reflux condenser, thermometer, and sample withdrawing tube is charged with the following ingredients: 32 milliliters MMA; 84 milliliters MACN. This mixture is heated to reflux, and after 30 minutes of refluxing, 0.02 milligrams of benzoyl peroxide is added. The reaction is allowed to continue for 20 hours with the resulting yield of 2 grams of copolymer. The reaction mixture is diluted with 1 liter of acetone and precipitated dropwise into 4 liters of methanol. The precipitated copolymer is dissolved in 250 milliliters acetone and, again, precipitated in 1 liter of methanol. The precipitated copolymer is dried under vacuum for 48 hours. Analysis of the polymer indicated the copolymer composition contains 75 percent MACN with the remainder MMA. The molecular weight as determined by gel permeation chromotography is $M_w = 1.5 \times 10^5$ with a distribution of 2.2. One gram of this polymer is dissolved in 10 milliliters of cyclopentanol and filtered. A silicon wafer is spin-coated at 2,000 rpm with a resist solution. The resulting resist thickness is 1.0 micrometers. The resist-coated substrate is prebaked at 150 degrees C for one hour and exposed with a scanning electron beam to a dose of 8 microcoulombs/$cm^2$ at 20 kV. Development of the exposed film is effected by dipping into a solution of methyl isopropyl ketone, for six minutes.

Claims

1. Process for fabrication of an article comprising an operation, during which the article undergoing fabrication comprises an article surface and an overlying actinic processing layer consisting essentially of polymeric material, including the steps of (1) selectively exposing portions of the said processing layer to actinic radiation to define a pattern whereby ease of removal of the said portions of the processing layer by a developing agent is increased, said ease of removal being dependent upon effective lessening of molecular weight of the said polymeric material resulting from exposure by the said actinic radiation, (2) treating the said processing layer with said developing agent to selectively remove material within the said portions to produce a new patterned processing layer, and (3) treating the article undergoing fabrication with an altering agent which preferentially alters regions of the said article surface corresponding with exposed regions of the patterned processing layer,

CHARACTERIZED IN THAT

the said polymeric material consists of at least 80 weight percent of a copolymer which may be regarded as containing at least 50 weight percent of poly-alpha substituted acrylonitrile together with at least 5 weight percent of diluent.

2. Process according to claim 1,

CHARACTERIZED IN THAT

the said copolymer has a weight average molecular weight $M_w$ of from 500,000 to 5 million, and the alpha substituted acrylonitrile consists of at least one member within the structural formula

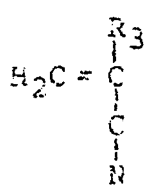

where $R_3$ equals $CH_3$, Cl or Br.

3. Process according to claim 2,

CHARACTERIZED IN THAT

the alpha substituted acrylonitrile is methacrylonitrile.

4. Process according to claim 1, 2 or 3,

CHARACTERIZED IN THAT

the said copolymer contains at least one comonomer diluent as represented by the structural formula

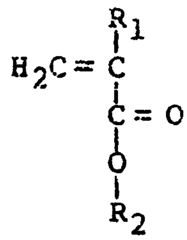

in which $R_1$ equals $CH_3$, Cl, Br, CN and $R_2$ equals 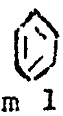 or alkyl (aliphatic or cyclic) group containing from 1 to 6 carbon atoms, with the said comonomer being included in amount of up to about 50 weight percent of the total copolymer weight made up of the said comonomer together with alpha substituted methacrylonitrile, the so defined copolymer constituents being referred to as "base copolymer".

5. Process according to claim 1, 2, 3 or 4

CHARACTERIZED IN THAT

the said copolymer contains up to 10 percent by weight of tetrahydrofurfuryl methacrylate incorporated as a comonomer.

6. Process according to any one of preceding claims 1-5,

CHARACTERIZED IN THAT

the said copolymer contains tetrahydrofurfuryl methacrylate in amount of up to 5 weight percent based on the total weight with "base copolymer", the entirety, in turn, constituting at least 80 weight percent of the said copolymer.

7. Process according to any one of claims 1-6,

CHARACTERIZED IN THAT

the said patterned processing layer is heated in the presence of oxygen to result in crosslinking

involving the said polymer.

8. Article produced by the process according to any one of claims 1-7.

9. Article comprising a substrate and an overlying layer of actinic radiation-sensitive material, said material consisting essentially of polymeric material,

CHARACTERIZED IN THAT

the said polymeric material consists of at least 80 weight percent of a copolymer which may be regarded as containing at least 50 weight percent of poly-alpha substituted acrylonitrile together with at least 5 weight percent of diluent.

10. Article according to claim 9,

CHARACTERIZED IN THAT

the said copolymer has a weight average molecular weight $M_w$ of from 500,000 to 5 million, and in which the alpha substituted acrylonitrile consists of at least one member within the structural formula

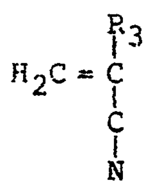

where $R_3$ equals $CH_3$, Cl or Br.

11. Article according to claim 9 or 10,

CHARACTERIZED IN THAT

the said copolymer contains at least one comonomer diluent as represented by the structural formula

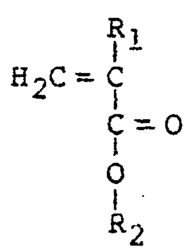

in which $R_1$ equals $CH_3$, Cl, Br, CN and $R_2$ equals 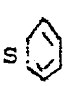 or alkyl (aliphatic or cyclic) group containing from 1 to 6 carbon atoms, with the said comonomer being included

in amount of up to about 50 weight percent of the total copolymer weight made up of the said comonomer together with alpha-substituted methacrylonitrile, the so defined copolymer constituents being referred to as "base copolymer".

12. Article according to claim 9, 10 or 11, CHARACTERIZED IN THAT the alpha-substituted acrylonitrile is methacrylonitrile.

13. Article according to any of claims 9-12, CHARACTERIZED IN THAT the said copolymer contains tetrahydrofurfuryl methacrylate in amount of up to 5 weight percent based on the total weight with "base copolymer", the entirety, in turn, constituting at least 80 weight percent of the said copolymer.

European Patent Office

# EUROPEAN SEARCH REPORT

0007976

Application number

EP 79 10 1528

| Category | Citation of document with indication, where appropriate, of relevant passages | Relevant to claim |
|---|---|---|
| X | FR - A - 2 299 665 (I.B.M.)<br>* the claims *<br>--- | 1-4, 7-12 |
| X | GB - A - 780 218 (E.I. DU PONT)<br>* the claims; page 2, lines 82-106 *<br>--- | 1-4, 7-12 |
| | DE - A - 2 227 008 (HITACHI)<br>* the claims *<br>--- | 1-4, 7-12 |
| | I.B.M. TECHNICAL DISCLOSURE BULLETIN, Vol. 16, no. 9, February 1974 NEW YORK, USA<br>E. GIPSTEIN et al.: "Sensitive positive electron-beam resists" page 3028<br>* page 3028 *<br>--- | 1-4 |
| | I.B.M. TECHNICAL DISCLOSURE BULLETIN, Vol. 16, no. 11, April 1974; NEW YORK, USA<br>O.V. NEED: "Polymethyl Alpha Cyano-acrylate Homopolymers and Copolymers as high-speed positive Electron-beam resists"<br>page 3745<br>* page 3745 *<br>--- | 1-4 |
| | I.B.M. TECHNICAL DISCLOSURE BULLETIN, Vol. 17, no. 5, October 1974, NEW YORK, USA<br>E.C. FREDERICHS et al.: "Positive resists with increased adhesion"<br>page 1354 | 1,5 |

CLASSIFICATION OF THE APPLICATION (Int. Cl.[2])

G 03 C 1/72
G 03 F 7/10

TECHNICAL FIELDS SEARCHED (Int.Cl.[2])

G 03 C 1/72
G 03 F 7/10

CATEGORY OF CITED DOCUMENTS

- X: particularly relevant
- A: technological background
- O: non-written disclosure
- P: intermediate document
- T: theory or principle underlying the invention
- E: conflicting application
- D: document cited in the application
- L: citation for other reasons
- &: member of the same patent family, corresponding document

✓ The present search report has been drawn up for all claims

| Place of search | Date of completion of the search | Examiner |
|---|---|---|
| The Hague | 22-08-1979 | RASSCHAERT |

European Patent Office

**EUROPEAN SEARCH REPORT**

0007976

Application number

EP 79 10 1528

| Category | Citation of document with indication, where appropriate, of relevant passages | Relevant to claim | CLASSIFICATION OF THE APPLICATION (Int. Cl.²) |
|---|---|---|---|
| | * page 1354 * | | |
| A | DE - A - 2 520 775 (HITACHI)<br>* page 5, line 5 - page 6, line 26 * | 5 | |
| P | JAPANESE PATENTS REPORT SECTION Ch CHEMICAL, Vol. 78, no. 42, 17 November 1978<br>DERWENT, LONDON (GB)<br>"Electron sensitive polymeric material"<br>page G4<br>& JP - B - 78 03 8193<br>* page G4, abstract of the JP - B - 78 03 8193 * | 1,5 | TECHNICAL FIELDS SEARCHED (Int. Cl.²) |